# EUROPÄISCHE PATENTANMELDUNG

(11) **EP 2 328 387 A2**
(43) Veröffentlichungstag der Anmeldung: **01.06.2011**
(21) Anmeldenummer: 10014621.6
(22) Anmeldetag: 15.11.2010
(51) Int. Cl.: H05C 1/00, G01R 19/145, G01R 19/14, G01R 15/12

(54) **Vorrichtung zur Ermittlung eines Zustands einer Elektrozaunanlage**

(30) Priorität: 20.11.2009 DE 202009015870 U
(71) Anmelder: PATURA KG, 63925 Laudenbach (DE)
(72) Erfinder: Allié, Bernd, 63897 Miltenberg (DE)
(74) Vertreter: Herrmann, Uwe

(57) **Zusammenfassung**

Die vorliegende Erfindung betrifft eine Vorrichtung zur Ermittlung eines Zustands einer Elektrozaunanlage mit wenigstens einem Spannungserfassungsmittel zur Erfassung und/oder Ermittlung einer an der Elektrozaunanlage anliegenden und/oder an die Elektrozaunanlage anlegbaren Spannung,

## Beschreibung

Die vorliegende Erfindung betrifft eine Vorrichtung zur Ermittlung eines Zustands einer Elektrozaunanlage mit wenigstens einem Spannungserfassungsmittel zur Erfassung und/oder Ermittlung einer an der Elektrozaunanlage anliegenden und/oder an die Elektrozaunanlage anlegbaren Spannung.

Für die Überwachung zur Erhaltung der Sicherheit von Elektrozaunanlagen ist es bereits bekannt, mittels sogenannter Digital-Voltmeter regelmäßig den Zustand der Elektrozaunanlage zu überprüfen. So muss beispielsweise sichergestellt sein, dass die sogenannte Hütespannung am Zaun an jeder Stelle des Zaunes mindestens 2000 V beträgt. Weiter wird empfohlen, für schwierige bzw. langhaarige Tiere eine Hütespannung von ca. 4000 V anzulegen.

Dementsprechend sind Elektrozaungeräte mit entsprechender Leistung bzw. Impulsenergie einzusetzen, die auch bei Verlusten z. B. durch Bewuchs in der Lage sind, eine entsprechende Hütespannung an der Elektrozaunanlage bzw. an den Zaun, insbesondere den Zaundraht oder die Zaunlitze anzulegen. Für die regelmäßige Überprüfung wird mittels des Digital-Voltmeters an mehreren Stellen der Elektrozaunanlage ermittelt, ob die gewünschte und teilweise auch vorgeschriebene Hütespannung am Zaun, insbesondere am Zaundraht anliegt.

Wünschenswert wäre es jedoch, nicht nur die anliegende Hütespannung erfassen zu können, sondern auch weitere wichtige Parameter zur Beurteilung des Zustands der Elektrozaunanlage ermitteln zu können.

Es ist daher die Aufgabe der vorliegenden Erfindung, eine Vorrichtung zur Ermittlung des Zustands einer Elektrozaunanlage in vorteilhafter Weise weiterzubilden, insbesondere dahingehend, dass weitere Einflussfaktoren zur Beurteilung des Zustands der Elektrozaunanlage mittels der Vorrichtung ermittelbar sind.

Diese Aufgabe wird erfindungsgemäß gelöst durch eine Vorrichtung zur Ermittlung eines Zustands einer Elektrozaunanlage mit den Merkmalen des Anspruchs 1. Danach ist vorgesehen, dass eine Vorrichtung zur Ermittlung eines Zustands einer Elektrozaunanlage mindestens ein Spannungserfassungsmittel zur Erfassung und/oder Ermittlung einer an der Elektrozaunanlage anliegenden und/oder an die Elektrozaunanlage anlegbaren Spannung aufweist, wobei die Vorrichtung weiter wenigstens ein Simulationsmittel aufweist, mittels dessen eine Fremdkontaktbelastung der Elektrozaunanlage simulierbar ist. Insbesondere besteht eine solche Elektrozaunanlage aus wenigstens einem Spannungserzeugungsgerät sowie einem mit dem Spannungserzeugungsgerät in Verbindung stehenden Zaun bestehend aus einem oder mehreren Zaundrähten, über die ein Stromimpuls abgebbar ist. Beispielsweise ergibt sich der Vorteil, dass mittels der Vorrichtung ein Zustand erfassbar und/oder ermittelbar ist, der einem Zustand entspricht, wenn die Elektrozaunanlage durch einen Fremdkontakt, wie beispielsweise dem Kontakt eines Fremdkörpers mit einem Teil der Elektrozaunanlage, belastet wird. Somit ist es möglich, vorteilhafterweise genau die Spannung zu ermitteln, die in einem Belastungszustand anliegt. Durch diesen Messwert kann die Hütesicherheit des Zaunes bzw. der Elektrozaunlage deutlich besser beurteilt werden, da alle Problembereiche, die an einer Elektrozaunanlage, insbesondere im Bereich des Zaunes selbst vorhanden sein können, wie mangelhafte Erdung, schlechte leitfähige Leitermaterialien, insbesondere beim Zaundraht, schlechte Verbindungen und schlecht leitfähige Bodenverhältnisse diesen Messwert beeinflussen. Der Betreiber des Elektrozaunes kann somit rechtzeitig auf vorhandene bzw. aufkommende Probleme reagieren.

Vorzugsweise besteht das Simulationsmerkmal aus einem in das Gerät integrierten Belastungswiderstand. Denkbar ist es, dass dieser durch den Nutzer des Geräts zuschaltbar ist, etwa durch Betätigung eines Schalters oder dergleichen.

Des Weiteren kann vorgesehen sein, dass die simulierbare Fremdkontaktbelastung der Impedanz oder dem Widerstand eines Tierkörpers entspricht. Dadurch ergibt sich der Vorteil, dass genau der Spannungswert ermittelbar ist, der dem Wert entspricht, wenn ein Tier die Elektrozaunanlage bzw. den Elektrozaun berührt.

Weiter ist denkbar, dass die simulierbare Fremdkontaktbelastung einer Impedanz oder einem Widerstand von bis zu 5000 Ohm, insbesondere einer Impedanz oder einem Widerstand von 50 Ohm bis 5000 Ohm entspricht. Eine Impedanz oder ein Widerstand von bis zu 5000 Ohm ist sehr vorteilhaft geeignet, den Kontakt eines Tierkörpers mit der Elektrozaunanlage zu simulieren.

Darüber hinaus ist möglich, dass die simulierbare Fremdkontaktbelastung hinsichtlich Impedanz oder Widerstand einstellbar ist. Insbesondere ist in diesem Zusammenhang denkbar, dass Impedanz oder Widerstand hinsichtlich Beschaffenheit und Eigenschaften der zu hütenden Tiere auf der mittels der Elektrozaunanlage umzäunten Weide oder des entsprechend umzäunten Bereichs angepasst sind.

Vorteilhafterweise ist denkbar, dass das Simulationsmittel einschaltbar und/oder ausschaltbar ist. Vorteilhafterweise ist denkbar, dass durch Betätigen eines Schalters die zusätzliche Belastung hinzuschaltbar ist, um beispielsweise den Kontakt eines Tierkörpers mit der Elektrozaunanlage zu simulieren. Ohne entsprechende Betätigung des Schalters ist es möglich, beispielsweise nur die übliche Zaunspannung zu erfassen bzw. zu ermitteln.

Des Weiteren kann vorgesehen sein, dass das Spannungserfassungsmittel derart beschaffen ist, dass mittels des Spannungserfassungsmittels der Verlauf einer an der Elektrozaunanlage anliegenden und/oder an die Elektrozaunanlage anlegbaren Spannung ermittelbar ist und anhand des Verlaufs dieser Spannung der Spitzenwert der Spannung ermittelbar ist.

Es ist denkbar, dass wenigstens ein Stromstärkemessmittel vorgesehen ist, mittels dessen die Stromstärke eines an der Elektrozaunanlage anliegenden und/oder an die Elektrozaunanlage anlegbaren Stromes messbar ist. Dadurch ergibt sich der Vorteil, die Einhaltung des maximal zulässigen Ampere-Werts an der Elektrozaunanlage überprüfen zu können.

Ferner ist möglich, dass wenigstens ein Eingabemittel vorhanden ist, wobei mittels des Eingabemittels die Vorrichtung aktivierbar und/oder deaktivierbar ist und/oder das Simulationsmittel aktivierbar und/oder deaktivierbar und/oder einstellbar ist und/oder das Spannungserfassungsmittel und/oder das Stromstärkemessmittel aktivierbar und/oder deaktivierbar ist. Es ist denkbar, dass das Eingabemittel ein Schalter ist. Genau so gut kann vorteilhafterweise vorgesehen sein, dass das Eingabemittel durch einen Touchscreen ausgebildet ist.

Darüber hinaus ist es möglich, dass wenigstens ein Ausgabemittel vorhanden ist, mittels dessen der Wert für Spannung, Stromstärke, Impulsenergie, Stromflussrichtung und/oder der Wert der simulierbaren Fremdkontaktbelastung ausgebbar, insbesondere anzeigbar ist, vorzugsweise mittels eines Displays anzeigbar ist.

Vorteilhafterweise ist weiter denkbar, dass mittels des Ausgabemittels der zuletzt gemessene Wert für Spannung, Stromstärke, Impulsenergie, Stromflussrichtung und/oder der Wert der simulierbaren Fremdkontaktbelastung ausgebbar, insbesondere anzeigbar ist, vorzugsweise mittels eines Displays anzeigbar ist. Dadurch ergibt sich der Vorteil, beispielsweise den zuletzt gemessenen Wert bzw. die zuletzt gemessenen Werte mit den aktuell gemessenen Werten bzw. dem aktuell gemessenen Wert abgleichen zu können.

Außerdem ist möglich, dass das Ausgabemittel ein akustisches Ausgabemittel ist und/oder ein akustisches Ausgabemittel umfasst. So ist vorteilhafterweise denkbar, dass neben dem Display zugleich ein Lautsprecher vorgesehen ist. Mittels des Lautsprechers können beispielsweise die aktuell gemessenen Werte ausgegeben werden. Denkbar ist aber alternativ oder auch zugleich, dass mittels des Lautsprechers ein Warnton ausgegeben wird, wenn der oder die gemessenen Werte unterhalb eines vorgegebenen Schwellenwertes liegen. Dadurch ergibt sich der Vorteil, den Nutzer auf gefährliche Werte, z. B. eine unterhalb der vorgeschriebenen Hütespannung liegende, am Zaun anliegende Spannung aufmerksam zu machen.

Vorteilhafterweise kann vorgesehen sein, dass die Vorrichtung tragbar ausgeführt ist. Insbesondere ist es von Vorteil, wenn die Vorrichtung Abmessungen und ein entsprechendes Gewicht aufweist, so dass die Vorrichtung vom Nutzer in einer Hand gehalten werden kann.

Weiter ist möglich, dass die Vorrichtung einen Messschlitz aufweist, mittels dessen die Vorrichtung in die Elektrozaunanlage einhängbar ist, insbesondere an beliebiger Stelle im und/oder an die Elektrozaunanlage einhängbar ist.

Des Weiteren kann vorgesehen sein, dass die Vorrichtung einen Messfühler aufweist, mittels dessen die Vorrichtung mit der Elektrozaunlage zur Ermittlung eines Zustands der Elektrozaunanlage in Kontakt bringbar ist. Dadurch ergibt sich der Vorteil, auch schwer zugängliche Bereiche der Elektrozaunanlage überprüfen zu können.

Vorteilhafterweise kann ferner vorgesehen sein, dass die Vorrichtung ein Übertragungsmittel aufweist, mittels dessen wenigstens ein mittels der Vorrichtung ermittelter Wert an eine externe Datenverarbeitungsanlage übertragbar ist. Eine derartige Datenverarbeitungsanlage kann beispielsweise ein Computer oder Laptop sein. Denkbar ist, mittels des Übertragungsmittels die ermittelten Werte zur Datensicherung an den Computer zu übertragen. Denkbar ist aber auch zugleich, dass mittels der externen Datenverarbeitungsanlage Einstellungen an der Vorrichtung vorgenommen werden können. So ist insbesondere denkbar, einen voreingestellten Wert für die Fremdkontaktbelastung mittels der externen Datenverarbeitungsanlage zu überprüfen und auch abändern zu können.

Weitere Einzelheiten und Vorteile der Erfindung sollen nun anhand eines in der Zeichnung dargestellten Ausführungsbeispiels näher erläutert werden. Es zeigt:

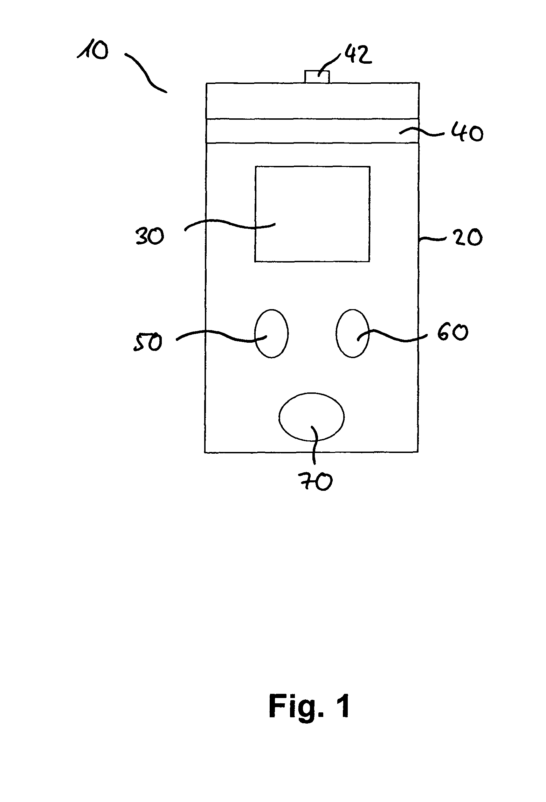

Figur 1: eine schematische Darstellung einer erfindungsgemäßen Vorrichtung zur Ermittlung eines Zustands einer Elektrozaunanlage.

Figur 1 zeigt in schematischer Darstellung eine Vorrichtung 10 zur Ermittlung eines Zustands einer Elektrozaunanlage. Die Vorrichtung 10 weist dabei ein nichtleitendes Gehäuse 20 auf, das vorzugsweise aus schlagzähem und belastungsfähigem Kunststoff ausgeführt ist. Im oberen Bereich der Vorrichtung 10 ist ein Messschlitz 40 angeordnet, mittels dessen die Vorrichtung in einen Zaundraht oder eine Zaunlitze einhängbar ist. Dadurch wird es möglich, den Zustand der Elektrozaunanlage an der Stelle, an der die Vorrichtung 10 eingehängt ist, ermitteln zu können.

Hierzu weist die Vorrichtung 10 ein Spannungserfassungsmittel zur Erfassung und Ermittlung der an dieser Stelle anliegenden Spannung am Elektrozaun auf. Der Wert der ermittelten Spannung kann über das Display 30 ausgegeben werden. Vorteilhafterweise ist es möglich, den gesamten Spannungsverlauf auszugeben. Denkbar ist aber auch, nur den Spitzenwert, also die maximal anliegende Spannung auszugeben.

Weiter weist die Vorrichtung 10 ein Stromstärkeerfassungsmittel auf, mittels dessen die an der Stelle, an der die Vorrichtung in den Zaun eingehängt ist, anliegende Stromstärke ermittelbar ist. Weiter kann mittels des Stromstärkeerfassungsmittels auch die Stromrichtung erfasst werden. Die Richtung kann mittels eines Pfeils im Display 30 angezeigt werden, beispielsweise wenn die Stromrichtung von links nach rechts ist durch einen entsprechenden nach rechts zeigenden Pfeil im Display 30 und, sofern die Stromrichtung von rechts nach links ist, durch einen im Display 30 nach links zeigenden Richtungspfeil. Denkbar ist, dass die ermittelte Stromstärke hinsichtlich ihres Verlaufes oder aber nur hinsichtlich des Maximalwertes angezeigt wird.

Sollte ein Einhängen des Messschlitzes 40 in die Elektrozaunanlage nicht möglich sein, kann an einer beispielsweise entsprechend unzugänglichen Stelle mittels des Messfühlers 42 die dort anliegende Spannung und/oder Stromstärke ermittelt werden.

Darüber hinaus weist die Vorrichtung 10 Eingabemittel 50 und 60 auf. Mittels des als Schalter 50 ausgeführten Eingabemittels 50 ist es möglich, die Vorrichtung 10 zu aktivieren. Sollte innerhalb einer voreingestellten Zeitspanne von beispielsweise 2 Minuten die Vorrichtung 10 nicht mit einer bestromten Elektrozaunanlage, insbesondere mit dem bestromten Zaundraht oder der bestromten Zaunlitze in Kontakt gebracht werden, so kann vorgesehen sein, dass sich die Vorrichtung 10 selbsttätig abschaltet. Denkbar ist weiter, dass mittels des Schalters 50 die Vorrichtung 10 sowohl ein- als auch ausschaltbar ist.

Weiter weist die Vorrichtung 10 einen Schalter 60 auf, mittels dessen ein nicht näher gezeigtes Simulationsmittel aktivierbar ist. Mittels des Simulationsmittels kann eine Fremdkontaktbelastung der Elektrozaunanlage simuliert werden. Dabei ist vorgesehen, dass die simulierbare Fremdkontaktbelastung der Impedanz bzw. dem Widerstand eines Tierkörpers entspricht und in einem Bereich von 0 bis 5000 Ohm, beispielsweise 1000 Ohm, liegt. Durch das Betätigen des Schalters 60 kann somit am Elektrozaun die Berührung durch ein Tier bzw. eine Belastung simuliert werden, wie sie typischer Weise durch Kontakt des Zaundrahtes mit Grasbewuchs auftreten kann. Somit kann der Benutzer durch Betätigen des Schalters 60 diese zusätzliche Belastung hinzuschalten.

Ohne Betätigung des Schalters 60 wird die übliche Zaunspannung und anliegende Stromstärke ohne Belastung über das Display 30 angezeigt. Nach Betätigen des Schalters 60 wird jedoch diejenige Spannung angezeigt, die ein Tier typischer Weise an der Messstelle verspüren würde.

Des Weiteren ist ein als Lautsprecher 70 ausgeführtes zusätzliches Ausgabemittel 70 vorgesehen, mittels dessen Warntöne ausgegeben werden können. Ein Warnton wird mittels des Lautsprechers 70 ausgegeben, wenn die ermittelte Spannung an der Messstelle unterhalb eines Wertes von 2000 V liegt. Denkbar ist weiter, dass in vorteilhafter Ausführungsform der Vorrichtung 10 die auf dem Display angezeigten Werte akustisch ausgegeben werden.

Weiter weist die Vorrichtung 10 ein nicht näher dargestelltes Übertragungsmittel auf, mittels dessen die Vorrichtung 10 drahtlos, aber auch alternativ drahtgebunden mit einem Computer verbindbar ist. Mittels des Computers ist es möglich, die voreingestellten Werte, insbesondere die Werte für die Fremdkontaktbelastung einzustellen. Darüber hinaus ist es möglich, mittels des Computers den Schwellwert für das Auslösen des Warntones, der mittels des Lautsprechers 70 ausgegeben wird, zu verändern. Über das Übertragungsmittel können weiter sämtliche ermittelten Werte an den Computer zum Zwecke der Datensicherung bzw. Datenspeicherung übertragen werden. Dadurch ergibt sich der Vorteil, lückenlos im Sinne einer Qualitätssicherung die ermittelten Werte zum Zustand der Elektrozaunanlage speichern zu können.

## Patentansprüche

1. Vorrichtung (10) zur Ermittlung eines Zustands einer Elektrozaunanlage mit wenigstens einem Spannungserfassungsmittel zur Erfassung und/oder Ermittlung einer an der Elektrozaunanlage anliegenden und/oder an die Elektrozaunanlage anlegbaren Spannung,
**dadurch gekennzeichnet,**
**dass** die Vorrichtung (10) weiter wenigstens ein Simulationsmittel aufweist, mittels dessen eine Fremdkontaktbelastung der Elektrozaunanlage simulierbar ist.

2. Vorrichtung (10) zur Ermittlung eines Zustands einer Elektrozaunanlage nach Anspruch 1, **dadurch gekennzeichnet, dass** die simulierbare Fremdkontaktbelastung der Impedanz oder dem Widerstand eines Tierkörpers entspricht.

3. Vorrichtung (10) zur Ermittlung eines Zustands einer Elektrozaunanlage nach Anspruch 1 oder 2, **dadurch gekennzeichnet, dass** die simulierbare Fremdkontaktbelastung einer Impedanz oder einem Widerstand von bis zu 5000 Ohm, insbesondere einer Impedanz oder einem Widerstand von 50 Ohm bis 5000 Ohm entspricht.

4. Vorrichtung (10) zur Ermittlung eines Zustands einer Elektrozaunanlage nach einem der vorhergehenden Ansprüche, **dadurch gekennzeichnet, dass** die simulierbare Fremdkontaktbelastung hinsichtlich Impedanz oder Widerstand einstellbar ist.

5. Vorrichtung (10) zur Ermittlung eines Zustands einer Elektrozaunanlage nach einem der vorhergehenden Ansprüche, **dadurch gekennzeichnet, dass** das Simulationsmittel einschaltbar und/oder ausschaltbar ist.

6. Vorrichtung (10) zur Ermittlung eines Zustands einer Elektrozaunanlage nach einem der vorhergehenden Ansprüche, **dadurch gekennzeichnet, dass** das Spannungserfassungsmittel derart beschaffen ist, dass mittels des Spannungserfassungsmittels der Verlauf einer an der Elektrozaunanlage anliegenden und/oder an die Elektrozaunanlage anlegbaren Spannung ermittelbar ist und anhand des Verlaufs dieser Spannung der Spitzenwert der Spannung ermittelbar ist.

7. Vorrichtung (10) zur Ermittlung eines Zustands einer Elektrozaunanlage nach einem der vorhergehenden Ansprüche, **dadurch gekennzeichnet, dass** wenigstens ein Stromstärkemessmittel vorgesehen ist, mittels dessen die Stromstärke eines an der Elektrozaunanlage anliegenden und/oder an die Elektrozaunanlage anlegbaren Stromes messbar ist.

8. Vorrichtung (10) zur Ermittlung eines Zustands einer Elektrozaunanlage nach einem der vorhergehenden Ansprüche, **dadurch gekennzeichnet, dass** wenigstens ein Eingabemittel (50, 60) vorhanden ist, wobei mittels des Eingabemittels (50, 60) die Vorrichtung (10) aktivierbar und/oder deaktivierbar ist und/oder das Simulationsmittel aktivierbar und/oder deaktivierbar und/oder einstellbar ist und/oder das Spannungserfassungsmittel und/oder das Stromstärkemessmittel aktivierbar und/oder deaktivierbar ist.

9. Vorrichtung (10) zur Ermittlung eines Zustands einer Elektrozaunanlage nach einem der vorhergehenden Ansprüche, **dadurch gekennzeichnet, dass** wenigstens ein Ausgabemittel (30, 70) vorhanden ist, mittels dessen der Wert für Spannung, Stromstärke, Impulsenergie, Stromflussrichtung und/oder der Wert der simulierbaren Fremdkontaktbelastung ausgebbar, insbesondere anzeigbar ist, vorzugsweise mittels eines Displays (30) anzeigbar ist.

10. Vorrichtung (10) zur Ermittlung eines Zustands einer Elektrozaunanlage nach einem der vorhergehenden Ansprüche, **dadurch gekennzeichnet, dass** mittels des Ausgabemittels (30, 70) der zuletzt gemessene Wert für Spannung, Stromstärke, Impulsenergie, Stromflussrichtung und/oder der Wert der simulierbaren Fremdkontaktbelastung ausgebbar, insbesondere anzeigbar ist, vorzugsweise mittels eines Displays (30) anzeigbar ist.

11. Vorrichtung (10) zur Ermittlung eines Zustands einer Elektrozaunanlage nach einem der vorhergehenden Ansprüche, **dadurch gekennzeichnet, dass** das Ausgabemittel (70) ein akustisches Ausgabemittel (70) ist und/oder ein akustisches Ausgabemittel (70) umfasst.

12. Vorrichtung (10) zur Ermittlung eines Zustands einer Elektrozaunanlage nach einem der vorhergehenden Ansprüche, **dadurch gekennzeichnet, dass** die Vorrichtung (10) tragbar ausgeführt ist.

13. Vorrichtung (10) zur Ermittlung eines Zustands einer Elektrozaunanlage nach einem der vorhergehenden Ansprüche, **dadurch gekennzeichnet, dass** die Vorrichtung einen Messschlitz (40) aufweist, mittels dessen die Vorrichtung (10) in die Elektrozaunanlage einhängbar ist, insbesondere an beliebiger Stelle im und/oder an die Elektrozaunanlage einhängbar ist.

14. Vorrichtung (10) zur Ermittlung eines Zustands einer Elektrozaunanlage nach einem der vorhergehenden Ansprüche, **dadurch gekennzeichnet, dass** die Vorrichtung (10) einen Messfühler (42) aufweist, mittels dessen die Vorrichtung (10) mit der Elektrozaunlage zur Ermittlung eines Zustands der Elektrozaunanlage in Kontakt bringbar ist.

15. Vorrichtung (10) zur Ermittlung eines Zustands einer Elektrozaunanlage nach einem der vorhergehenden Ansprüche, **dadurch gekennzeichnet, dass** die Vorrichtung (10) ein Übertragungsmittel aufweist, mittels dessen wenigstens ein mittels der Vorrichtung (10) ermittelter Wert an eine externe Datenverarbeitungsanlage übertragbar ist.
